# EUROPÄISCHE PATENTSCHRIFT

(11) **EP 1 381 707 B1**
(45) Veröffentlichungstag und Bekanntmachung des Hinweises auf die Patenterteilung: **31.08.2005**
(21) Anmeldenummer: 02766571.0
(22) Anmeldetag: 25.04.2002
(51) Int. Cl.: C23C 14/02, C23C 14/06, C23C 16/02, C23C 16/30, C23C 16/32, C23C 16/34, C23C 16/36, B23B 27/14

(54) **VERFAHREN ZUR HERSTELLUNG EINER BESCHICHTUNG AUF EINEM SPANENDEN WERKZEUG UND ZERSPANUNGSWERKZEUG**
METHOD FOR PRODUCING A COATING ON A MACHINING TOOL AND A MACHINING TOOL
PROCEDE D'OBTENTION D'UN REVETEMENT SUR UN OUTIL TRAVAILLANT PAR ENLEVEMENT DE COPEAUX, ET OUTIL D'USINAGE PAR ENLEVEMENT DE COPEAUX Y RELATIF

(30) Priorität: 26.04.2001 AT 681012001
(43) Veröffentlichungstag der Anmeldung: 21.01.2004
(73) Patentinhaber: BÖHLERIT G.m.b.H. & Co. KG, A-8605 Kapfenberg (AT)
(72) Erfinder: VOIGT, Klaus, A-8605 Parschlug (AT); PITONAK, Reinhard, A-8600 Bruck/Mur (AT); KISSELBACH, Andreas, 73431 Aalen (DE)
(74) Vertreter: Wildhack, Helmut
(86) Internationale Anmeldenummer: PCT/AT2002/000127
(87) Internationale Veröffentlichungsnummer: WO 2002/088414

(56) Entgegenhaltungen:
- EP-A- 0 878 558
- DE-A- 3 510 608
- US-A- 5 722 803
- PATENT ABSTRACTS OF JAPAN vol. 012, no. 056 (C-477), 19. Februar 1988 (1988-02-19) & JP 62 202071 A (TOYOTA CENTRAL RES & DEV LAB INC), 5. September 1987 (1987-09-05)

## Beschreibung

Die Erfindung bezieht sich auf ein Verfahren zur Herstellung einer Beschichtung auf zumindest Teilen der Oberfläche im Bereich der Schneidkante(n) eines spanenden Werkzeuges.

Weiters betrifft die Erfindung ein Zerspanungswerkzeug mit einer zumindest auf Teilen der Oberfläche im Bereich der Schneidkante(n) aufgebrachten Hartstoffschicht.

Ebenso ist die Erfindung auf die Verwendung eines Zerspanungswerkzeuges mit einer Beschichtung gerichtet.

Spanende Werkzeuge aus Schnellarbeitsstahl, hochchromlegiertem Werkzeugstahl oder Hartmetall, die im Bereich der Schneidkante(n) eine Oberflächenbeschichtung aus einer Verbindung, insbesondere Titanverbindung, zum Beispiel Titannitrid, Titankarbid oder Titankarbonitrid, aufweisen, sind bekannt. Es gehören weiters Hartstoffbeschichtungen mit Verbindungen von anderen Elementen der Gruppen 4,5 und 6 des Periodensystems, beispielsweise Vanadinnitrid, Zirkonnitrid, Chromnitrid, Niobnitrid und dergleichen zum Stand der Technik. Auch wurden schon aus mehreren Einzelschichten gebildete Beschichtungen, die insbesondere dem Ausgleich unterschiedlich hoher Ausdehnungskoeffizienten des Substrates und der Deckschicht dienen sollen, bekannt.

Die Beschichtungsverfahren an sich, wie beispielsweise physikalische - (PVD) und chemische- (CVD) Dampfniederschlagungsverfahren, sind dem einschlägigen Fachmann geläufig.

Alle bekannten Schichtmaterialien weisen gegenüber zumindest der Matrix des Werkzeuggrundkörpers bzw. des Substrates eine höhere Härte auf und können daher die Abriebfestigkeit der Oberflächen an der Schneidkante bzw. die Standzeit der Schneidkante selbst des Werkzeuges erhöhen. Höhere Schichthärten führen oft zu einer vorteilhaften Änderung des Verschleißverhaltens des Werkzeuges.

Die Verschleißfestigkeit eines beschichteten Werkzeuges bzw. dessen Standzeit im Betrieb hängt im wesentlichen von der mechanischen Stabilität der Beschichtung sowie den chemischen Eigenschaften der Hartstoffschicht ab. Um einer Verbindung zwischen Substrat und der Hartstoffbeschichtung eine möglichst hohe Stabilität zu verteihen, sollte einerseits die Rauhigkeit des Substrates eine von dessen Materialeigenschaften abhängige maximale Profilhöhe R_{Y} nach DIN 4762 von allenfalls unter 25 µm aufweisen, wobei geringste Profilhöhen keine wesentliche Verbesserung der Haftfestigkeit, jedoch einen erhöhten Erstellungsaufwand erbringen und die Gefahr von plastischen Deformationen von Spitzen beinhalten können. Andererseits erhöhen große Beschichtungsstärken von über 10 bis 15 µm die Tendenz einer Ablösung. Bei einer Bearbeitung von Materialien, die bei dieser anorganische und/oder organische Bestandteile bzw. dergleichen Verbindungen freisetzen, kann die Werkzeugstandzeit trotz Beschichtung erniedrigt sein, weil Korrosionserscheinungen der Verschleißminderung entgegengerichtet sind.

Der Erfindung liegt nun die Aufgabe zugrunde, ein Verfahren zur Beschichtung der Oberfläche im Schneidkantenbereich eines spanenden Werkzeuges anzugeben, welches Verfahren eine vergrößerte Haftfestigkeit am Werkzeuggrundkörper, eine erhöhte Korrosionsbeständigkeit und eine verringerte Abrasion der Beschichtung erbringt.

Ein weiteres Ziel der Erfindung ist die Schaffung eines Zerspanungswerkzeuges mit einer Hartstoffbeschichtung, welches Werkzeug eine wesentlich verlängerte Standzeit im Betrieb mit hoher Beanspruchung aufweist.

Letztlich ist die Erfindung auf eine besondere Verwendbarkeit eines Zerspanungswerkzeuges gerichtet.

Die vorhin gestellte Aufgabe der Erfindung wird bei einem eingangs genannten Verfahren dadurch gelöst, daß die zu beschichtende Fläche des Werkzeuges bzw. Substrates schleifbearbeitet und im Querprofil der Fläche eine maximale Profilhöhe R_{Y} von unter 8 µm eingestellt wird, worauf eine Profilkuppenglättung bis zu einer Profiltaltiefe Yᵥ von 1 bis 5 µm, vorzugsweise 1 bis 3µm erfolgt und auf die derart gebildete Substratfläche eine Schicht aus Nitrid, Karbid, Karbonitrid, gegebenenfalls mit Sauerstoffanteilen, zum Beispiel Oxikarbid, von mindestens zwei Elementen der Gruppen 4,5 und 6 des Periodensystems mit einer Dicke von 0,5 bis 5 µm aufgebracht wird.

Die mit der Erfindung erzielten Vorteile bestehen im wesentlichen darin, daß besondere Voraussetzungen für eine hohe Haftfestigkeit der Beschichtung geschaffen werden und daß die neue Schicht eine vergrößerte Härte, verringerte Reibung und eine erhöhte chemische Stabilität besitzt.

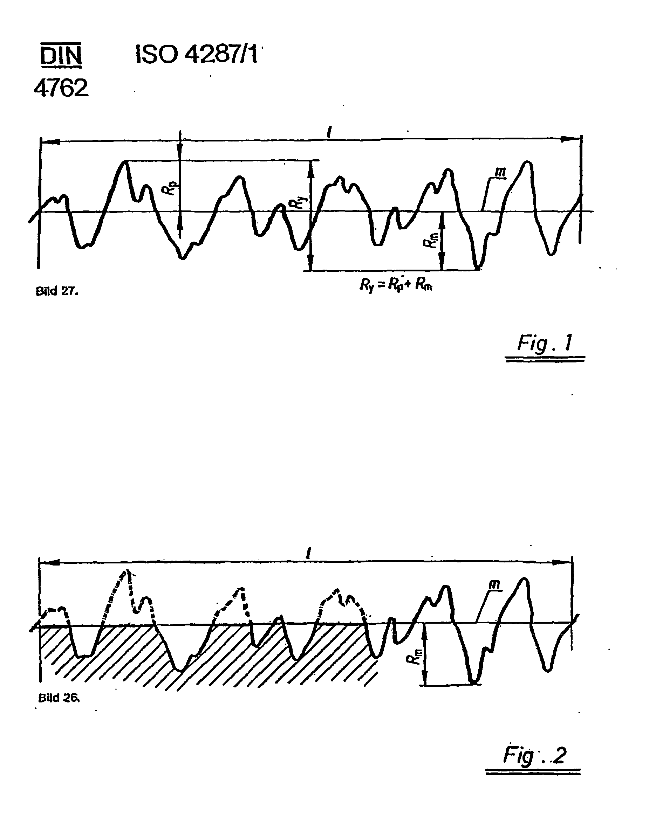

Wenn die zu beschichtende Werkzeugoberfläche schleifbearbeitet wird, besitzt diese in der Folge ein Querschnittsprofil senkrecht zur Schleifrichtung mit scharfen Spitzen, unabhängig von der Rauhtiefe bzw. der maximalen Profilhöhe R_{Y} nach DIN 4762, Bild 27, wie auch in der dem Normblatt entnommenen Fig. 1 dargestellt ist.

Es wurde gefunden, daß die auf den scharfen Spitzen des Substrates aufgebrachten Beschichtung an diesen Stellen geschwächt ist, welche Stellen insbesondere bei oberflächenparallelen Belastungen einen Ausgangspunkt für eine stellenweise Beschichtungsablösung darstellen können. Erfindungsgemäß ist eine Profilkuppenglättung vorgesehen, die einerseits die nachteilig wirkenden Profilerhebungen zumindest teilweise beseitigt, andererseits eine Rauhigkeit des Substrates, die die Haftfestigkeit der Beschichtung fördert, sicherstellt, wie Fig. 2 zeigt. Wird nun eine maximale Profiltaltiefe nach DIN 4762 von R_{M} = 1 bis 5 µm in vorteilhafter Weise von 1,5 bis 3 µm eingestellt, so ist die Haftfestigkeit der Beschichtung durch Wegfall der nachteiligen Spitzenauswirkungen verstärkt.

Erfolgt auf eine derart gebildete Substratoberfläche erfindungsgemäß das Aufbringen einer Hartstoffschicht bestehend aus einer Verbindung von mindestens zwei Metall-Elementen der Gruppen 4,5 und 6 des Periodensystems, so wird im Vergleich mit Verbindungen gemäß dem Stand der Technik sowohl eine hochfeste Verankerung der Beschichtung als auch eine Eigenschaftsveränderung der Schicht durch eine Beeinflussung des Atomgitters erreicht. Es ist dadurch synergetisch möglich, die Haftfestigkeit der Hartstoffbeschichtiung zu erhöhen und deren Eigenschafts auf ein Anforderungsprofil auszurichten.

Nitrid-Karbid- und Karbonitrid- Verbindungen der Elemente der Gruppen 4 und 5 des Periodensystems weisen durchwegs hohe Härte auf, sind jedoch gegen chemische Korrosion weniger beständig. Hingegen sind die Elemente Chrom, Molybdän und Wolfram hochkorrosionsbeständig, was überraschenderweise auch für die Verbindungen diese Metalle Gültigkeit hat. Erfindungsgemäß können nun Metall-Mischverbindungen, zum Beispiel (Mel+Mell+...) N auf Substrate aufgebracht werden, wobei die Beschichtung gleichzeitig Korrosionsbeständigkeit und hohe Härte aufweist.

Zur Durchführung einer Profilkuppenglättung kann vorteilhaft sein, wenn diese durch ein Ionenätzen mit einer Elektrizitätsmenge in Coulomb (C) von 5,6 bis 18,2 C/cm², vorzugsweise von 8,0 bis 16,3 C/cm², mit einer Zeitdauer von 800 bis 1900 s, vorzugsweise von 1000 bis 1500 s, erfolgt.

Bei einem Ionenätzen oder Zerstäuben, insbesondere der Profilspitzen, muß die Spannung größer als die Zerstäubungsschwelle sein und liegt vorteilhaft zwischen 150 und 280 V. Wird in günstiger Weise eine Metall-Ionenätzung durchgeführt, sollte die Spannung einen Wert zwischen 800 und 1500 V aufweisen.

Im Hinblick auf eine gleichzeitig hohe Härte bei guter Korrosionsbeständigkeit kann in günstiger Weise vorgesehen werden, daß eine Beschichtung mit einer Verbindung von mindestens je einem Element aus den Gruppen 6 und 4 des Periodensystems erfolgt. Einerseits ist durch die Elemente Cr, Mo und W der Gruppe 6 des Periodensystems die Korrosionsbeständigkeit erhöht, andererseits erfolgt eine besonders ausgeprägte Atomgitterverspannung durch die Elemente der Gruppe 4 des Periodensystems in der Verbindung.

Das weitere Ziel der Erfindung wird bei einem Zerspanungswerkzeug der gattungsgemäßen Art dadurch erreicht, daß die Beschichtungsfläche des Werkzeuges bzw. des Substrates im Querprofil der Fläche, bezogen auf die Richtung der Schleifbearbeitung, eine profilkuppengeglättete Form mit einer Profiltaltiefe von Rₘ von 1 bis 5 µm aufweist und die Hartstoffschicht aus Nitrid, Karbid, Karbonitrid, gegebenenfalls mit Sauerstoffanteilen, zum Beispiel Oxikarbid, von mindestens zwei Elementen der Gruppen 4,5 und 6 des Periodensystems mit einer Dicke von 0,5 bis 5,0 µm gebildet ist.

Eine profilkuppengeglattete Form der Bearbeitungsfläche bzw. der Substratoberfläche mit eine Profiltaltiefe Yᵥ im Querprofil von 1 bis 5 µm, in vorteilhafter Weise von 1 bis 3 µm, stellt den erfindungsgemäßen Vorteil dar, daß einerseits eine günstige Verankerung mit hoher Verbindungsstärke der Schicht erreicht wird, andererseits eine weitgehend ebenmäßige spitzenfreie Ausbildung des oberen Außenflächenteiles vorliegt, was auch aus Fig. 2 hervorgeht. Die als Beschichtung aufgebrachten Metall- Mischverbindungen sind auf die letztlich an das Werkzeug gestellten Anforderungen ausrichtbar und vermitteln diesem in Verbindung mit der erfindungsgemäßen Oberflächenausführung bei einer Dicke von 0,5 bis 5,0 µm besonders gute Gebrauchseigenschaften. Dieser Vorteil ist besonders ausgeprägt bei Werkzeugen, die durch Äbschleifen der Spanfläche geschärft werden, weil die Beschichtungen an den Flanken der Schneidkanten besonders hohe stimseitig gerichtete Beanspruchungen, die ein Ablösen der Schicht fördern, erfährt. Auch eine Beschichtung der Spanfläche bei einem Schärfen des Werkzeuges durch Abtragung der Flanken bewirkt eine Leistungssteigerung.

Wenn, wie gefunden wurden, die Hartstoffschicht mit Elementen der Gruppen 6 und 4 des Periodensystems gebildet ist, kann gezielt durch den jeweiligen Anteil der Metalle in der Verbindung bei einer Bearbeitung von Werkstoffen, welche dabei korrosive Medien abgeben, ein Angriff und/oder Schneidkantenabtrag des Werkzeuges wesentlich vermindert werden.

Beispielsweise hat sich bei einer Bearbeitung von Holz und Holzverbundstoffen eine Beschichtung mit einem Nitrid oder Karbonitrid von Chrom und Titan mit einem Verhältnis von bis zu 40 Atom-% Titan, vorzugsweise von 5 bis 15 Atom-% Titan, auf einem Schnellarbeitsstahlsubstrat als besonders günstig herausgestellt. die Haftfestigkeit von polymerisierten organischen Verbindungen an der Beschichtung war minimiert.

An den diesbezüglichen Untersuchungen soll die Erfindung weiter dargestellt werden.
Bei einer Vickers-Härteprüfung mit einer Belastung von 0,5 N wurden für reines Chromnitrid Werte von 1700 bis 2000 HV und für reines Titannitrid solche von ca. 2300 HV ermittelt.

Reines Chromnitrid wies gute Korrosionsbeständigkeit auf, die durch Anteile von Molybdän sowie Wolfram in der Verbindung weiter verbessert wurde. Anteile von Titan, Zirkon, Hafnium, Niob und Vanadin verminderten jedoch im steigenden Maße ab Anteilen von 10 bis 40 Atom-% die Beständigkeit gegen Korrosion, erhöhten aber die Härte der Verbindung bzw. Beschichtung und wirkten gelegentlich versprödend.

An Beschichtungen aus Chrom-Titan-Nitrid wurde gefunden, daß mit steigendem Titananteil ab ca. 10 Atom-% Titan die Korrosionsbeständigkeit sinkt, wobei ab ca. 30 Atom-% der diesbezügliche Abfall verstärkt ausgebildet ist, was einen chemisch bedingten Verschleiß vergrößert. Hingegen wird durch die Einlagerung von Ti-Atomen in das Chromnitridgitter, die Verspannung desselben und damit die Härte erhöht; bei ca. 30 Atom-% Titan ergaben sich Härtewerte der Schicht von 3000 HV. Weiters hat Chromnitrid im Vergleich mit Stahl, zum Beispiel Schnellarbeitsstahl, einen geringen Ausdehnungskoeffizienten, wodurch die Spannung in der Beschichtung, insbesondere im Bereich von ausgeprägten Profilspitzen vom Substrat, hoch ist. Titananteile im Chromnitrid vergößem den Ausdehnungskoeffizienten der Verbindung und verringern die Spannungen in der Schicht am Substrat.

Durch praktische Erprobungen wurde bei der Zerspanung von Kieferholz gefunden, daß dafür die Summeneigenschaft des Zerspanungswerkzeuges mit einer maximalen Profiltaltiefe der Substratoberfläche R_{M} von 1 bis 5 µm, vorzugsweise 1 bis 3 µm, und einer Beschichtung mit Chrom-Titan-Nitrid, wobei der Titananteil 5 bis 14 Atom-% beträgt, optimiert ist.

## Patentansprüche

1. Verfahren zur Herstellung einer Beschichtung auf zumindest Teilen der Oberfläche im Bereich der Schneidkante(n) eines spanenden Werkzeuges, **dadurch gekennzeichnet, daß** die zu beschichtende Fläche des Werkzeuges bzw. Substrates schleifbearbeitet und im Querprofil der Fläche eine maximale Profilhöhe R_{Y} von unter 8 µm eingestellt wird, worauf eine Profilkuppenglättung bis zu einer maximalen Profiltaltiefe R_{M} von 1 bis 5 µm erfolgt und auf die derart gebildete Substratfläche eine Schicht aus Nitrid, Karbid, Karbonitrid, gegebenenfalls mit Sauerstoffanteilen, zum Beispiel Oxikarbid, von mindestens zwei Elementen der Gruppen 4,5 und 6 des Periodensystemes mit einer Dicke von 0,5 bis 5 µm aufgebracht wird.

2. Verfahren nach Anspruch 1, **dadurch gekennzeichnet, daß** die Profilkuppenglättung durch ein Ionenätzen mit einer Elektrizitätsmenge von 5,6 bis 18,2 C/cm², vorzugweise mit 8,0 bis 16,3 C/cm², mit einer Zeitdauer von 800 bis 1900 s, vorzugsweise von 1000 bis 1500 S, erfolgt.

3. Verfahren nach Anspruch 1 oder 2, **dadurch gekennzeichnet, daß** die Profilkuppenglättung durch ein Edelgas-Ionenätzen bei einer Spannung zwischen 150 V bis 280 V erfolgt.

4. Verfahren nach Anspruch 1 oder 2, **dadurch gekennzeichnet, daß** die Profilkuppenglättung durch ein Metall - Ionenätzen bei einer Spannung zwischen 800 V und 1500 V erfolgt.

5. Verfahren nach einem der Ansprüche 1 bis 4, **dadurch gekennzeichnet, daß** die Beschichtung mit einer Verbindung von mindestens je einem Element aus den Gruppen 6 und 4 des Periodensystems erfolgt.

6. Zerspanungswerkzeug mit einer zumindest auf Teilen der Oberfläche im Bereich der Schneidkanten augebrachten Hartstoffschicht, **dadurch gekennzeichnet, daß** die Beschichtungsfläche des Werkzeuges bzw. des Substrates im Querprofil der Fläche, bezogen auf die Schleifbearbeitung, eine profilkuppengeglättete Form mit einer maximalen Profiltaltiefe R_{M} von 1 bis 5 µm aufweist und die Hartstoffschicht aus Nitrid, Karbid, Karbonitrid, gegebenenfalls mit Sauerstoffanteilen, zum Beispiel Oxikarbid, von mindestens zwei Elementen der Gruppen 4,5 und 6 des Periodensystems mit einer Dicke von 0,5 bis 5,0 µm gebildet ist.

7. Zerspanungswerkzeug nach Anspruch 6, **dadurch gekennzeichnet, daß** die Hartstoffschicht mit Elementen der Gruppen 6 und 4 des Periodensystems gebildet ist.

8. Zerspanungswerkzeug nach Anspruch 6 oder 7, **dadurch gekennzeichnet, daß** in die Hartstoffschicht die Elemente Aluminium und/oder Silizium und/oder Bor eingelagert sind.

9. Zerspanungswerkzeug nach einem der Ansprüche 6 bis 8, **dadurch gekennzeichnet, daß** der Werkzeuggrundkörper bzw. das Substrat pulvermetallurgisch hergestellt ist.

10. Verwendung von Zerspanungswerkzeugen nach den Ansprüchen 6 bis 9 für die Bearbeitung von Materialien, die bei dieser anorganische und/oder organische Bestandteile bzw. Verbindungen freisetzen, welche chemisch korrosiv sind und/oder sich im Bereich der Schneid - und/oder Freiflächen des Werkzeuges niederschlagen und/oder polymerisieren.

11. Verwendung von Zerspanungswerkzeugen nach den Ansprüchen 6 bis 10 für eine Bearbeitung von Holz, Kunststoff oder zumindest mit Holzteilen und/oder Kunstharzen gebildeten Gegenständen.

## Claims

1. Method for producing a coating on at least portions of the surface near the cutting edge(s) of a machining tool, **characterized in that** the surface of the tool or substrate to be coated is ground and that a maximum profile depth R_{y} is set to below 8 µm in the cross-section of the surface, followed by a profile smoothing step to a maximum profile depth R_{M} of 1 to 5 µm and that onto the received substrate surface a layer of nitride, carbide, carbonitride, as the case may be with oxygen e.g. Oxycarbide, of at least two elements of the groups 4, 5 and 6 of the classification of elements is deposited with a thickness of 0,5 to 5µm.

2. Method according to claim 1, **characterized in that** the profile smoothing step is conducted by ion etching with a quantity of electricity of 5,6 to 18,2 C/cm², preferably with 8,0 to 16,3 C/cm², for a duration of 800 to 1900 s, preferably for 1000 to 1500 s.

3. Method according to claim 1 or 2, **characterized in that** the profile smoothing step is conducted by inert gas-ion etching at a voltage of 150 to 280 V.

4. Method according to claim 1 or 2, **characterized in that** the profile smoothing step is conducted by metal-ion etching at a voltage of 800 to 1500 V.

5. Method according to one of the claims 1 to 4, **characterized in that** the coating is done with a compound of al least one element of each of the groups 6 and 4 of the classification of elements.

6. Machining tool with a coating of hard material deposited on at least portions of the surface near its cutting edge(s) **characterized in that** the coating surface of the tool or substrate has with regard to the grinding procedure a profile smoothed shape with a maximum profile depth R_{M} of 1 to 5 µm in the cross-section of the surface and that the layer of hard material is made of nitride, carbide, carbonitride, as the case may be with oxygen e.g. Oxycarbide, of at least two elements of the groups 4, 5 and 6 of the classification of elements with a thickness of 0,5 to 5µm.

7. Machining tool according to claim 6, **characterized in that** the layer of hard material is made from elements of the groups 6 and 4 of the classification of elements.

8. Machining tool according to claim 6 or 7, **characterized in that** the elements aluminium and/or silicon and/or boron are embedded into the layer of hard material.

9. Machining tool according to one of the claims 6 to 8, **characterized in that** the base body of the machining tool or substrate is made produced by a powder metallurgical procedure.

10. Use of machining tools according to the claims 6 to 9 for the treatment of materials that set free inorganic and/or organic parts or compounds during said treatment said compounds being chemically corrosive and/or deposit and/or polymerize near the cutting- and/or free surfaces of the tool.

11. Use of machining tools according to the claims 6 to 10 for a treatment of wood, plastics or subjects made of at least wooden parts and/or artificial resins or plastics.

## Revendications

1. Procédé d'obtention d'un revêtement sur au moins des parties de la surface dans la zone de l'arête (des arêtes) tranchante(s) d'un outil d'usinage par enlèvement de copeaux, **caractérisé en ce que** la surface à revêtir de l'outil ou du substrat est traitée par polissage et que l'on ajuste, vue en profil transversal de la surface, une hauteur de profil maximal Rᵥ de moins de 8 µm, après quoi on effectue un lissage du dôme de profil jusqu'à une profondeur de profil maximale R_{M} de 1 à 5 µm, et que l'on applique sur la surface de substrat ainsi formé une couche de nitrure, de carbure, de carbonitrure, le cas échéant avec des portions d'oxygène, par exemple d'oxycarbure, d'au moins deux éléments des colonnes 4, 5 et 6 de la classification périodique avec une épaisseur de 0,5 à 5 µm.

2. Procédé selon la revendication 1, **caractérisé en ce que** le lissage du dôme de profil est effectué par corrosion ionique avec une quantité d'éléctricité de 5,6 à 18,2 C/cm², préférablement avec de 8,0 à 16, 3 C/cm², avec une durée de 800 à 1900 s, préférablement de 1000 à 1500 s.

3. Procédé selon la revendication 1 ou 2, **caractérisé en ce que** le lissage du dôme de profil est effectué par corrosion ionique à gaz noble à une tension entre 150 V à 280 V.

4. Procédé selon la revendication 1 ou 2, **caractérisé en ce que** le lissage du dôme de profil est effectué par corrosion ionique à métal à une tension entre 800 V à 1500 V.

5. Procédé selon une quelconque des revendications **1** à 4, **caractérisé en ce que** le revêtement est effectué avec un composé d'au moins un élément respectif des colonnes 6 et 4 de la classification périodique.

6. Outil d'usinage par enlèvement de copeaux comprenant au moins une couche d'un matériau à résistance mécanique élevée appliquée sur au moins des parties de la surface dans la zone des arêtes tranchantes, **caractérisé en ce que** la surface à revêtir de l'outil ou du substrat, vue en profil transversal de la surface, en se référant au traitement de polissage, comprend une forme lissée au dôme de profil, qui a une profondeur de profil maximale R_{M} de 1 à 5 µm, et que la couche d'un matériau à résistance mécanique élevée est formée par un nitrure, un carbure, un carbonitrure, le cas échéant avec des portions d'oxygène, par exemple d'oxycarbure, d'au moins deux éléments des colonnes 4, 5 et 6 de la classification périodique avec une épaisseur de 0,5 à 5 µm.

7. Outil d'usinage par enlèvement de copeaux selon la revendication 6, **caractérisé en ce que** la couche d'un matériau à résistance mécanique élevée est formé avec des éléments des colonnes 6 et 4 de la classification périodique.

8. Outil d'usinage par enlèvement de copeaux selon la revendication 6 ou 7, **caractérisé en ce que** les éléments d'aluminium et/ou de silicium et/ou de bore sont déposés dans la couche d'un matériau à résistance mécanique élevée.

9. Outil d'usinage par enlèvement de copeaux selon une quelconque des revendications 6 à 8, **caractérisé en ce que** le corps de base de l'outil ou le substrat est produit par la métallurgie des poudres.

10. L'utilisation des outils d'usinage par enlèvement de copeaux selon les revendications 6 à 9 pour usiner des matériaux, qui dégagent, lors de l'usinage, des composants ou des composés, qui sont chimiquement corrosives et/ou se précipitent ét/ou polymérisent dans la zone des surfaces tranchantes et/ou libres de l'outil.

11. L'utilisation des outils d'usinage par enlèvement de copeaux selon les revendications 6 à 10 pour usiner du bois, de la matière plastique ou des articles formé au moins avec des parties en bois et/ou en matière plastique.
